# EUROPÄISCHE PATENTSCHRIFT

(11) **EP 1 968 188 B1**
(45) Veröffentlichungstag und Bekanntmachung des Hinweises auf die Patenterteilung: **08.08.2012**
(21) Anmeldenummer: 07004878.0
(22) Anmeldetag: 09.03.2007
(51) Int. Cl.: H01L 23/34, H01L 23/373, H01L 23/64, H01L 25/00, H01L 25/04, H01L 25/07, H01L 25/16, H05H 1/46, H03F 3/217, H01J 37/32, H05H 1/36

(54) **Klasse-D Verstärkeranordnung**
Class D amplifier assembly
Agencement d'amplificateur de classe D

(43) Veröffentlichungstag der Anmeldung: 10.09.2008
(73) Patentinhaber: HÜTTINGER Elektronik GmbH + Co. KG, 79111 Freiburg (DE)
(72) Erfinder: Kirchmeier, Thomas, 79331 Teningen (DE); Glück, Michael, 79111 Freiburg (DE); Hintz, Gerd, Dr., 79292 Pfaffenweiler (DE)
(74) Vertreter: Kohler Schmid Möbus

(56) Entgegenhaltungen:
- EP-A- 1 601 015
- EP-A- 1 601 098
- EP-A2- 0 427 143
- DE-A1- 3 134 680
- DE-A1- 3 908 996
- DE-A1-102005 036 116
- FR-A- 2 681 187
- KR-A- 20040 096 374
- US-A- 4 733 137
- US-A- 5 077 595
- US-A- 5 103 283
- US-A- 5 113 145
- US-A- 5 398 160
- US-A- 5 646 445
- US-A1- 2004 179 341
- US-A1- 2005 146 257
- US-B1- 6 222 260
- US-B1- 6 229 388
- US-B1- 6 291 880
- US-B1- 6 373 705
- US-B2- 6 636 429
- US-B2- 6 777 881
- US-B2- 6 784 538
- US-B2- 6 906 404
- US-B2- 7 034 345
- US-B2- 7 081 671
- HIDEAKI FUJITA ET AL: "A 2-MHz 2-kW Voltage-Source Inverter for Low-Temperature Plasma Generators: Implementation of Fast Switching with a Third-Order Resonant Circuit" IEEE TRANSACTIONS ON INDUSTRY APPLICATIONS, IEEE SERVICE CENTER, PISCATAWAY, NJ, US, Bd. 35, Nr. 1, Februar 1999 (1999-02), XP011022505 ISSN: 0093-9994
- "Designer's Guide to Power Products. Application Manual. 2nd edition. AN358; AN367" 1990, SGS THOMSON MICROELECTRONICS , XP002438491 AN367: page 560 wiring precautions. AN358: III - Layout for high speed switching. Fig. 4a; and V - Conclusion
- ATTWOOD B E: "DESIGN PARAMETERS IMPORTANT FOR THE OPTIMIZATION OF VERY-HIGH-FIDELITY PWM (CLASS D) AUDIO AMPLIFIERS" JOURNAL OF THE AUDIO ENGINEERING SOCIETY, AUDIO ENGINEERING SOCIETY, NEW YORK, NY, US, Bd. 31, Nr. 11, November 1983 (1983-11), Seiten 842-853, XP000942479 ISSN: 1549-4950

## Beschreibung

Die Erfindung betrifft eine HF-Klasse D Verstärkeranordnung, die zum Betrieb an Versorgungsspannungen ≥100V und bei Ausgangsleistungen ≥ 1kW geeignet ist, mit einer aus zwei in Serie geschalteten schaltenden Elementen, insbesondere MOSFETs, gebildeten Halbbrücke mit zwei Versorgungsspannungsanschlüssen und einem zwischen den schaltenden Elementen liegenden Ausgangsanschluss, wobei parallel zu der Serienschaltung der schaltenden Elemente ein Bypasskondensator vorgesehen ist.

Von Hochfrequenz spricht man in der Regel dann, wenn die Signallaufzeit eines Signals von Punkt A nach Punkt B auf einer Leiterbahn im Bereich der Periodendauer des Signals liegt. Diese Bedingung ist für Frequenzen ≥ 3 MHz gegeben. Unter Hochfrequenz im Sinne der Erfindung werden also Frequenzen ≥ 3 MHz verstanden. Bei Hochfrequenz spielen Leiterbahnlängen und Beschaffenheit eine wesentliche Rolle. Es kann nicht mehr vereinfachend davon ausgegangen werden, dass ein Signal am Punkt 1 anliegend zur gleichen Zeit auch an Punkt 2, der wenige cm entfernt liegt anliegt und mit einer Leiterbahn verbunden ist. Vielmehr liegt das Signal erst wenige ns später an und hat seinen Wert unter Umständen auch schon geändert. Für solche Frequenzen ≥ 3 MHz sind daher eigene Technologien notwendig. Für kleinere Frequenzen bekannte Technologien lassen sich nicht auf den Frequenzbereich, in dem sich die vorliegende Erfindung bewegt, übertragen.

Für die Anregung von Plasmaprozessen mittels Hochfrequenz (z.B. zum RF-Sputtern, Ätzen oder zur Anregung von Gaslasern) eignen sich neben linearen Verstärkern (Klasse A und B Verstärker, die den Nachteil einer hohen Verlustleitung haben) vor allem HF-Generatoren mit einem oder mehreren schaltenden Elementen, die so genannten Klasse-D oder Klasse-E Verstärker. Der Klasse-E Verstärker hat den Nachteil, dass die Spannungen an den als Transistoren ausgebildeten schaltenden Elementen auf über das dreifache der DC- Versorgungsspannungen ansteigen, während der aus einer Brücke gebildete Klasse-D Verstärker die Spannungen an den Transistoren auf die Versorgungsspannung begrenzt.

Für den Klasse-D Verstärker werden häufig zwei in Serie geschaltete schaltende Elemente, z.B. MOSFETS, verwendet. Diese Verstärkeranordnung wird häufig als Halbbrücke bezeichnet. Die übliche Schaltung sieht wie folgt aus: Der an der positiven DC-Versorgungsspannung liegende obere Transistor oder Schalter (High Side Switch, HSS) ist mit seinem Drain-Anschluss an die positive DC-Versorgungsspannung (+V) angeschlossen und mit seinem Source-Anschluss an den Drain-Anschluss des unteren Transistors oder Schalters (Low Side Switch, LSS). Der Source-Anschluss des unteren Transistors ist an die negative DC-Versorgungsspannung (-V) angeschlossen. Das Ausgangssignal der Halbbrücke wird zwischen den beiden schaltenden Elementen abgegriffen (Source vom oberen und Drain vom unteren MOSFET). Angesteuert werden beide Transistoren jeweils über ihren Gate-Anschluss (Steueranschluss).

Der MOSFET Driver Hybrid DRF 1200 der Firma Advanced Power Technology ist ein MOSFET mit einem integriertem Treiberbaustein.

Aus der US 2005/0088855 A1 ist eine Halbbrücke mit Bypass-Kondensator bekannt. Weitere HF-Generatoren sind aus EP1601098, US6777881 und EP1601015 bekannt.

Aufgabe der vorliegenden Erfindung ist es, eine für hohe Frequenzen geeignete Verstärkeranordnung bereit zu stellen.

Diese Aufgabe wird erfindungsgemäß durch eine Verstärkeranordnung nach Anspruch 1 gelöst.

Alle schaltenden Elemente, haben eine Ausgangskapazität (Ausgangskapazität bei MOSFETs: Drain-Sourcekapazität Coss), die bei Hochfrequenzanwendungen nicht zu vernachlässigen ist. Bei jedem Einschalten unter Spannung muss ein MOSFET seine eigene Drain-Sourcekapazität über seinen Leitwiderstand R_{DSON} entladen und dabei Leistung verbrauchen (1/2 CU²). Je höher die Frequenz ist, mit der der MOSFET ein- und ausgeschaltet wird, je höher ist die Energie, die in dem MOSFET in Wärme umgewandelt wird. In der Halbbrücke muss er zusätzlich die Drain-Sourcekapazität des anderen MOSFETs, der zu diesem Zeitpunkt gesperrt ist, umladen, wobei auch eine Schwingung zwischen der Kapazität des MOSFETs und der Induktivität der Zuleitung angeregt wird. Daher sollen die MOSFETs der Halbbrücke bei hochfrequentem Schaltbetrieb und hoher Betriebsspannung unbedingt spannungslos einschalten. Dies wird durch einen induktiven Anteil der Lastimpedanz erreicht, der, wenn ein MOSFET sperrt, noch genügend Strom weiter fließen lässt, um die Kapazitäten des MOSFETs auf das Gegenpotential umzuladen, bevor der andere MOSFET einschaltet. Die Erfüllung dieser Bedingung wird als "Schaltentlastung", "Nullspannungsschalten" oder auch "Zero Voltage Switching, ZVS" bezeichnet.

Bei Plasmaprozessen kommt es sehr häufig zu Laständerungen, die in der Regel zu Lastfehlanpassungen führen. Diese werden zwar durch Impedanzanpassungsnetzwerke versucht zu unterbinden, dies erfolgt aber immer zeitlich verzögert und oft auch nicht vollständig.
Das Zusammenwirken von Schaltbrücke und Lastimpedanz für den Klasse-D Betrieb macht unmittelbar verständlich, dass bei Lastfehlanpassung das Nullspannungsschalten nicht mehr gewährleistet sein kann.

Die Entwicklung von Klasse D Verstärkern in der Hochfrequenztechnik (Frequenzen oberhalb 3 MHz) bei großen Spannungen und Leistungen galt bisher aus den folgenden Gründen als problematisch:
Transistoren für hohe Leistungen ≥ 1kW haben einen gewissen Platzbedarf, weil sie Wärmeenergie abführen können müssen (s.o. Entladen einer Kapazität über R_{DSON}) und den Strom auf eine gewisse Mindestfläche verteilen müssen. Je höher die Spannung ist, bei der die Transistoren betrieben werden, je größer müssen die Abstände der Anschlusspins sein. Das macht gewisse Mindestabmessungen nötig.

Den Strompfad von der positiven Versorgungsspannung über die beiden Transistoren zur negativen Versorgungsspannung nennt man Laststrompfad. Zusätzlich zum Laststrompfad existiert aber auch noch der so genannte Parasitärstrompfad. Der besteht im Wesentlichen aus dem so genanten Bypasskondensator zwischen der positiven Versorgungsspannung und der negativen Versorgungsspannung. Er dient der Vermeidung von Spannungseinbrüchen in der Versorgungsspannung bei den beim Schalten auftretenden Stromimpulsen in den schaltenden Transistoren. Außerdem verhindert er die Zerstörung der Transistoren aufgrund von Stromspitzen. Beim Zusammenschließen zweier Transistoren zu einer Halbbrücke und beim Anschließen des Bypass- Kondensators werden Teile des Laststrompfads und Teile des Parasitärstrompfads zu einem Strompfad (Schleife) zusammengeschaltet, der die schaltenden Transistoren und den Bypasskondensator enthält. Zuleitungen von den Versorgungsspannungsanschlüssen sind nicht Bestandteil dieses Strompfads. Dieser Strompfad weist Zuleitungsinduktivitäten und Kapazitäten, z.B. die Ausgangskapazität der MOSFETs (Coss), auf und bildet damit einen Schwingkreis. Dieser Schwingkreis wird durch das Ein- und Ausschalten der Transistoren angeregt. Wenn dieser Schwingkreis angeregt wird, z.B. wenn das Nullspannungsschalten nicht mehr erreicht werden kann, so schwingt er meist bei deutlich höheren Frequenzen (z.B. 80 MHz) als die Grundfrequenz (z.B. 13,56 MHz). Diese Schwingungen sind im Plasmaprozess unerwünscht und stören auch die Funktion und die Sicherheit des HF-Generators, in dem die Halbbrücke verwendet wird. Eine sinnvolle Dämpfung des Schwingkreises ist mit Leistungsverlust verbunden, der für diesen hohen Leistungsbereich extrem unerwünscht ist. Diese Problematik hat oft dazu geführt, dass Klasse D Verstärker für hohe Leistungen insbesondere bei Plasmaprozessen nicht zum Einsatz kamen und stattdessen auf die Verstärker der Klasse B oder C zurückgegriffen wurde, die eine deutlich höhere Verlustleistung aufweisen, oder auf einen Klasse E Verstärker. Am Transistor eines Klasse-E Verstärkers treten deutlich höhere Spannungen auf, so dass spannungsfestere und teurere Transistoren eingesetzt werden mussten. Da, wo Klasse D Verstärker bei hohen Leistungen für Plasmaprozesse doch eingesetzt wurden, war das Ausgangssignal oftmals nicht von der erforderlichen Qualität und besaß einen zu hohen Anteil an Oberwellen. Für die stetig steigenden Anforderungen an Prozessqualität sind diese Klasse D Verstärker jedoch nicht geeignet.

Bei spannungsgespeisten Halbbrücken dürfen sich niemals beide Transistoren gleichzeitig im leitenden Zustand befinden, weil sonst die Versorgungsspannung kurzgeschlossen würde. Das ist bei steigender Frequenz zunehmend schwierig sicherzustellen. Ausschlaggebend für das Ein- und Ausschalten der Transistoren ist die Spannung am Gate der Transistoren. Die langen Zuleitungen, die bei Transistoren hoher Leistung wegen des einzuhaltenden Mindestabstands notwendig sind, besitzen Zuleitungsinduktivitäten. Das Gate besitzt Kapazitäten zu Source und zu Drain. Wird nun die Spannung am Gate-Anschluss des Transistors auf einen Pegel gelegt, der ein Ein- oder Ausschalten des Transistors bewirken soll, so ist diese Spannung erst nach einer Umladezeit, die Abhängig von den Gate-Kapazitäten und Anschlussinduktivitäten ist, auch wirklich am Gate wirksam. Da diese Gate-Kapazitäten und Zuleitungsinduktivitäten zu Schwingungen neigen, ist es im Stand der Technik üblich, auch noch Widerstände zur Dämpfung vorzusehen. Dies vergrößert die Umladezeiten zusätzlich.

Besonders nachteilig ist bei Anordnungen des Standes der Technik die Exemplarstreuung der einzelnen Transistoren. Hier sind vor allem unterschiedliche Schwellspannungen ein Problem, weshalb Transistoren oftmals für den Einsatz in Brückenschaltungen ausgemessen und selektiert werden. Außerdem ist die Umladezeit von Transistor zu Transistor unterschiedlich lang. Die Zeitunterschiede sind häufig in einem Zeitbereich, der bei hohen Frequenzen nicht mehr vernachlässigt werden kann. Die Synchronisation der Transistoren ist schwierig.

Die Kapazitäten in dem aus Laststrompfadkreis und Parasitärstrompfad resultierenden Strompfad sind in Serie geschaltet, das heißt die Gesamtkapazität wird im Wesentlichen durch die kleinsten Kapazitäten bestimmt. Das sind die Ausgangskapazitäten in den Transistoren. Diese lassen sich nicht beliebig vermindern. Sie sind durch die Fläche der Transistoren bestimmt, die wiederum von der Strombelastbarkeit abhängt und damit letztlich von der Leistung, die die Halbbrücke schalten können soll.

Durch die erfindungsgemäß geringe Länge des Strompfads ist die Verstärkeranordnung besonders induktionsarm ausgebildet. Dadurch werden die unerwünschten Schwingungen, die auftreten, wenn ein Nullspannungsschalten wegen einer sich ändernden Last nicht möglich ist, zu hohen Frequenzen verschoben, die sich einfacher dämpfen lassen, bzw. durch die Begrenzung der Schaltgeschwindigkeit der schaltenden Elemente schon gar nicht mehr entstehen können. Die erfindungsgemäße Verstärkeranordnung ist besonders geeignet für die Verwendung in HF-Generatoren für Leistungen über 1kW mit Versorgungsspannungen über 100V und Frequenzen ≥ 3 MHz.

Wenn zusätzlich oder alternativ die Halbbrücke und der Bypasskondensator auf einer Fläche ≤ 30 cm² angeordnet sind, können Induktivitäten im Strompfad so gering gehalten werden, dass störende parasitäre Schwingungen vermieden bzw. zu so hohen Frequenzen verschoben werden, dass sie nicht mehr stören oder einfach bedämpft werden können. Die lokale Konzentration des Schwingkreises verringert seinen Einfluss auf andere Schaltkreise, Insbesondere auf die Taktsignalerzeugung.

Wenn zusätzlich oder alternativ der durch Kapazitäten und Induktivitäten im Strompfad durch die Halbbrücke und den Bypasskondensator gebildete (parasitäre) Schwingkreis eine Resonanzfrequenz ≥ 100 MHz aufweist, kann die bei Fehlanpassung entstehende Resonanzfrequenz einfach gedämpft werden. Da die Kapazität Coss gleich bleibt, bedeutet eine höhere Resonanzfrequenz, dass ein höherer Entladestrom früher auftritt, was wiederum zu verstärkter ohmscher Dämpfung (ohmschen Verlusten) führt.

Wenn zusätzlich oder alternativ die Verbindungsleitungen zwischen dem Bypasskondensator und den schaltenden Elementen sowie zwischen den schaltenden Elementen jeweils eine Länge ≤ 10mm, vorzugsweise ≤ 5mm, besonders bevorzugt ≤ 3mm aufweisen, sind die schaltenden Elemente besonders niederinduktiv fest miteinander verdrahtet. Anschlussleitungen (Bondingdrähte) werden hierbei als Bestandteil der Verbindungsleitungen verstanden. Die kurzen Leitungen bewirken eine Verkürzung des Strompfades durch die beiden schaltenden Elemente und den parallelen Bypasskondensator und somit eine Verringerung der Induktivitäten.

Die Verbindungsleitungen können flächig ausgeführt werden, zum Beispiel kann eine Verbindungsleitung als Fläche, z.B. als Kupferbahn, oder durch viele parallel geführte Leitungen in etwa so breit wie lang ausgebildet sein. Die Breite und Länge der Verbindungsleitungen, wobei die Breite durch mehrere parallel geführte Einzelverbindungsleitungen bestimmt sein kann, liegen also in derselben Größenordnung. Vorzugsweise entsprechen sich Länge und Breite der Verbindungsleitungen. Das reduziert die Induktivität der Leiterbahn.

Bei einer bevorzugten Ausführungsform kann zumindest eine Treiberanordnung vorgesehen sein, die an die Steueranschlüsse der schaltenden Elemente angeschlossen ist, wobei die Verbindungsleitungen der Treiberanordnung zu den schaltenden Elementen eine Länge ≤10mm, vorzugsweise ≤ 5mm, besonders bevorzugt ≤ 3mm aufweisen. Dadurch können auch die Induktivitäten in den Verbindungsleitungen reduziert werden, so dass auch eine induktionsarme Anbindung der Treiberanordnung möglich ist. Wenn die Treiberanordnung näher an den schaltenden Elementen, insbesondere den Gates der MOSFETs, angeordnet ist, sind die MOSFETs gegenüber der Miller-Rückkopplung der Schwingung im parasitären Schwingkreis weniger anfällig.

Zusätzlich oder alternativ können die Halbbrücke und der Bypasskondensator auf einem gemeinsamen Substrat angeordnet sein. Die Treiber für die Transistoren sind erfindungsgemäß auf dem Substrat angeordnet. Damit können besonders induktionsarme, kurze Verbindungsleitungen realisiert werden. Insbesondere sind die Halbleiter-Bausteine (Dice) direkt auf das Substrat aufgebracht und mit in, an oder auf dem Substrat angeordneten Verbindungsleitungsabschnitten direkt verbunden (gebondet). Sowohl MOSFETs als auch Treiber sind als Halbleiterbausteine ausgebildet. Weil von den Halbleiterbausteinen zu den Verbindungsleitungsabschnitten mehrere Anschlussleitungen (Bondingdrähte) parallel gelegt werden, ist die Verbindung besonders induktionsarm. Die Anschlussleitungen stellen zusammen mit den Verbindungsleitungsabschnitten Verbindungsleitungen dar. Zum Beispiel können die Verbindungsleitungen auch direkt von Halbleiterbaustein zu Halbleiterbaustein verdrahtet (gebondet) werden. Verbindungsleitungen können auf, in oder an dem Substrat besonders induktionsarm aufgebaut werden. Wenn die verdrahteten Halbleiter-Bausteine in einem geschlossenen Gehäuse untergebracht werden, können kürzere Sicherheitsabstände realisiert werden, ohne die Gefahr der Überschläge, weil die Gefahr einer Verschmutzung geringer ist und damit Mindestkriechstrecken kürzer realisiert werden können. Wenn die verdrahteten Halbleiter-Bausteine in einem Gehäuse vergossen werden, können noch kürzere Sicherheitsabstände realisiert werden, ohne die Gefahr der Überschläge, weil anstatt Kriechstrecken nun Isolationskoordinaten der Vergussmasse berücksichtigt werden können.

Eine besonders Platz sparende Anordnung mit kurzem Strompfad und kurzen Verbindungsleitungen zwischen den Bauelementen ergibt sich, wenn zumindest die Halbbrücke und der Bypasskondensator in einem Halbleiterbaustein integriert sind.

Weiter kann vorgesehen sein, dass zumindest die schaltenden Elemente auf einem Kühlkörper angeordnet sind. Dadurch kann eine unmittelbare Kühlung der schaltenden Elemente und somit eine Leistungsabfuhr erfolgen. Der Kühlkörper kann als Kühlplatte oder Multilayer-Platine ausgebildet sein. Wenn der Kühlkörper aus Keramik ausgebildet ist, kann er die Wärme besonders gut ableiten.

Die Verbindungsleitungen zwischen dem Bypasskondensator und den schaltenden Elementen können kurz und damit die Leitungsinduktivitäten gering gehalten werden, wenn der Bypasskondensator über oder unter den schaltenden Elementen angeordnet ist.

Auch wenn der Bypasskondensator als Substrat für die schaltenden Elemente ausgebildet ist, können extrem kurze Verbindungsleitungen realisiert werden. Außerdem kann der Bypasskondensator in diesem Fall auch als Kühlkörper für die schaltenden Elemente dienen.

Bei einer Ausführungsform kann vorgesehen sein, dass zumindest die Halbbrücke und der Bypasskondensator zu einem Modul zusammengefasst sind. Zwar ist es denkbar, auch eine Vollbrücke in einem Modul zu integrieren, für einen Klasse-D Betrieb ist dies jedoch nicht unbedingt notwendig, da zwischen den beiden Halbbrücken keine besonders induktionsarmen Pfade benötigt werden. Die Ausführung der Verstärkeranordnung mit nur zwei in Serie geschalteten schaltenden Elementen hat weiterhin den Vorteil, dass es kostengünstiger ist, zwei Halbbrückenmodule zu fertigen als ein Vollbrückenmodul. In einem Halbbrückenmodul sind weniger Bauteile. Somit sinkt die Wahrscheinlichkeit eines Fertigungsfehlers. Es steigt die Ausbeute (yield). Ein Modul im Sinne der Erfindung ist eine Baugruppe, die eine Einheit darstellt und als solche zum Beispiel in einen HF-Generator eingebaut werden kann.

Bei einer Weiterbildung kann vorgesehen sein, dass außer Masseanschlüssen das Modul keine Verbindung zum Kühlkörper aufweist. Somit ist das Modul gegenüber dem Kühlkörper elektrisch isoliert.

Weitere Vorteile ergeben sich, wenn alle Anschlüsse, an denen eine Spannung ≥100V anliegt als Anschlusspins oder Anschlussfahnen auf der dem Kühlkörper gegenüber liegenden Seite angeordnet sind. Durch diese Maßnahme kann eine Mindestkriechstrecke eingehalten werden, die bei hohen Spannungen notwendig ist. Dies ist häufig bei seitlich herausgeführten Anschlüssen nicht der Fall. Blechstreifen (Anschlussfahnen) bieten für hochfrequente Ströme einen niedrigeren Widerstand als Leitungen mit rundem Querschnitt. Mit nach oben gerichteten Anschlussfahnen oder Anschlusspins kann die Verstärkeranordnung für eine gute thermische Leitfähigkeit unmittelbar, ohne zusätzliche elektrische Isolierplatten auf dem Kühlkörper angeordnet werden. Die Anschlüsse können mit einer Leiterplatte, die oberhalb der Module angeordnet ist, verbunden, insbesondere daran angelötet werden.

Eine vorteilhafte Ausführungsform zeichnet sich dadurch aus, dass zwei in Reihe geschaltete Kondensatoren zwischen den Versorgungsspannungsanschlüssen vorgesehen sind. Durch diese Maßnahme kann ein Mittelpunkt zwischen einer positiven Versorgungsspannung +V und der negativen Versorgungsspannung -V erzeugt werden. Vorzugsweise sind diese Kondensatoren ebenfalls induktionsarm, d.h. mit kurzen Anschlussleitungen, angeschlossen. Vorteilhafterweise sind sie im Modul angeordnet.

Bei einer Weiterbildung kann vorgesehen sein, dass die Leitungen zu den Kondensatoren eine Länge ≤ 10mm, vorzugsweise ≤ 5mm, besonders bevorzugt ≤ 3mm aufweisen. Durch diese Maßnahme sind auch diese Kondensatoren induktionsarm angeschlossen.

Weitere Vorteile ergeben sich, wenn jeweils ein Kondensator zwischen der positiven Versorgungsspannung und Masse und der negativen Versorgungsspannung und Masse vorgesehen ist. Masse kann dann direkt niederinduktiv mit dem Kühlkörper verbunden werden.

Eine solche niederinduktive Verbindung ergibt sich insbesondere dadurch, dass die Verbindungsleitung des Kühlkörpers zu Masse eine Länge ≤10mm, vorzugsweise ≤ 5mm, besonders bevorzugt ≤ 3mm aufweist.

In den Rahmen der Erfindung fällt außerdem ein HF-Generator mit einer oben beschriebenen Verstärkeranordnung.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnung näher erläutert. Es zeigt:
- **Fig. 1**: eine schematische Darstellung einer erfindungsgemäßen Verstärkeranordnung;
- **Fig. 2**: die Anordnung der Verstärkeranordnung auf einem Kühlkörper;
- **Fig. 3**: eine Schaltung zur Realisierung eines Mittenpotentials;
- **Fig. 4**: eine Ausgestaltung einer Verstärkeranordnung;
- **Fig. 5**: eine Verstärkeranordnung in einem Gehäuse.

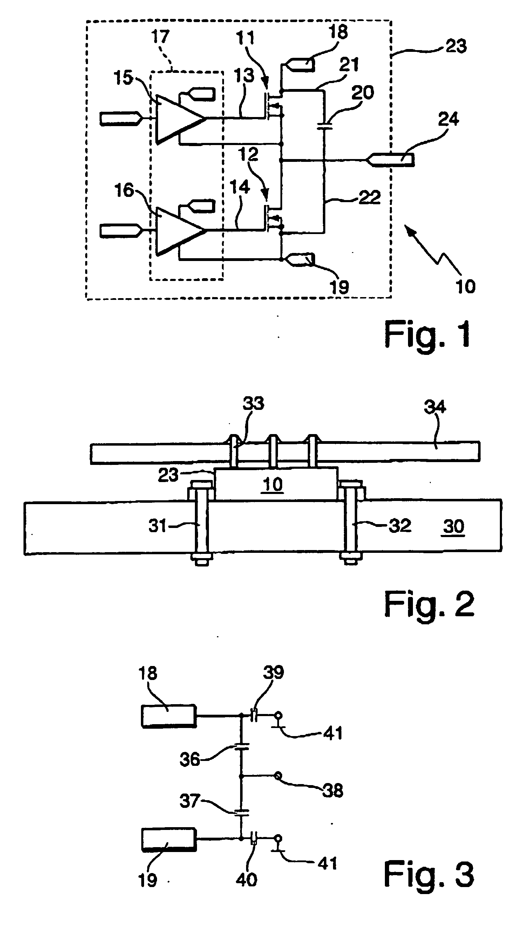

Die Figur 1 zeigt eine HF Klasse-D Verstärkeranordnung 10, welches zwei in Serie geschaltete als MOSFETs ausgebildete schaltende Elemente 11,12 umfasst, die eine Halbbrücke bilden. Die Steueranschlüsse 13,14 der schaltenden Elemente 11,12 sind jeweils durch einen Treiberbaustein 15,16 einer Treiberanordnung 17 angesteuert. Das obere schaltende Element 11 ist an eine positive Versorgungsspannung 18 und das untere schaltende Element 12 an eine negative Versorgungsspannung 19 angeschlossen. Zwischen den schaltenden Elementen 11, 12 liegt der Ausgangsanschluss 24.

Parallel zu den schaltenden Elementen 11,12 beziehungsweise zwischen die positive und negative Versorgungsspannung 18,19 ist ein Bypasskondensator 20 gestaltet. Die Verbindung zwischen den schaltenden Elementen 11,12 und die Verbindungsleitungen 21,22 zu dem Bypasskondensator 20 sind induktionsarm ausgebildet. Dies bedeutet, dass sie so kurz wie möglich sind. Insbesondere wird dadurch auch der Strompfad durch die schaltenden Elemente 12, 13 und den Bypasskondensator 20 sehr kurz. Im Ausführungsbeispiel ist die gesamte Verstärkeranordnung 10 in einem Gehäuse 23 angeordnet.

In der Figur 2 ist gezeigt, dass die Verstärkeranordnung 10, insbesondere deren schaltenden Elemente 11, 12 auf einem Kühlkörper 30 angeordnet ist und mit diesem mittels Schrauben 31,32 verschraubt ist. Über die Schrauben 31,32 wird eine Masseverbindung der Verstärkeranordnung 10 mit dem Kühlkörper 30 hergestellt. Anschlusspins 33 der Verstärkeranordnung 10 sind nach oben aus dem Gehäuse 23 herausgeführt, so dass sie mit einer Leiterplatte 34, die oberhalb der Verstärkeranordnung 10 angeordnet ist, verbunden werden können.

In der Figur 3 sind zwei Kondensatoren 36,37 gezeigt, die zwischen die positive Versorgungsspannung 18 und die negative Versorgungsspannung 19 geschaltet sind. Durch sie wird ein Mittelpunkt 38 (Mittenpotenzial) zwischen den Versorgungsspannungen 18,19 realisiert. Weiterhin sind Kondensatoren 39,40 zwischen den Versorgungsspannungen 18,19 und Masse 41 vorgesehen. Die Masse 41 kann niederinduktiv mit dem Kühlkörper 30 verbunden sein.

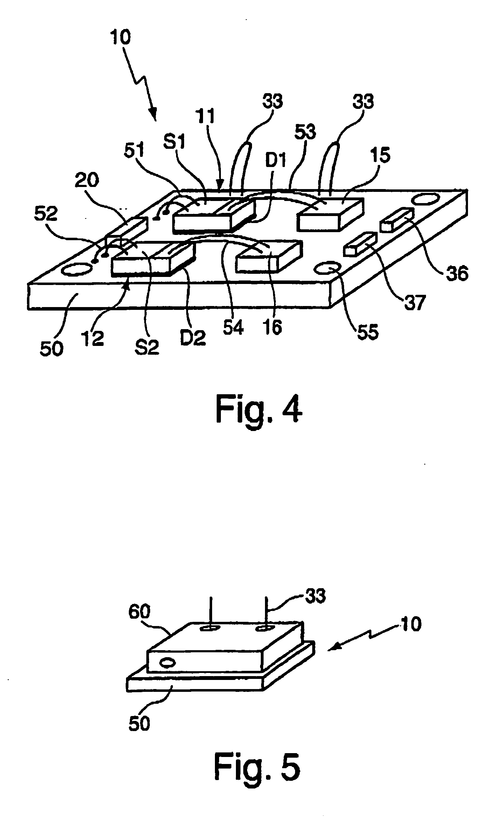

In der Fig. 4 ist eine Realisierungsmöglichkeit der Verstärkeranordnung 10 gezeigt. Die schaltenden Elemente 11, 12 sind jeweils als Halbeiterbausteine (Dice) ausgebildet und auf einem Substrat 50 angeordnet, welches als Kühlkörper dienen kann. Die schaltenden Elemente 11, 12 sitzen mit ihrem Drain D1, D2 jeweils auf dem Substrat 50 und sind von unten kontaktiert. Der Sourceanschluss S1, S2 liegt jeweils oben. Die Source-Anschlüsse S1, S2 sind über Anschlussleitungen 51, 52, die als Bondingdrähte ausgeführt sind, mit im Substrat verlaufenden Verbindungsleitungsabschnitten verbunden. Die Anschlussleitungen 51, 52 werden auch möglichst kurz gehalten und können als Bestandteil der Verbindungsleitungen zwischen Bauelementen betrachtet werden. Der Bypass-Kondensator 20 ist ebenfalls auf dem Substrat 50 angeordnet.

Die Gate-Anschlüsse (Steueranschlüsse) G1, G2 sind ebenfalls obenliegend und über Anschlussleitungen 53, 54, die ebenfalls als Bondingdrähte ausgeführt sind, mit auf dem Substrat 50 angeordneten Treiberbausteinen 15, 16 verbunden. Die Kondensatoren 36, 37 sind ebenfalls auf dem Substrat 50 angeordnet. Anschlusspins 33 bzw. Anschlussfahnen stehen von dem Substrat 50, in welchem unter anderem die Verbindungsleitungen 21, 22 verlaufen, ab. Das Substrat weist Befestigungseinrichtungen 55 - hier Durchgangslöcher - zur Befestigung des Substrats 50 auf.

Bei der Ausführungsform gemäß Fig. 5 ist die Verstärkeranordnung 10 in einem Gehäuse 60 auf einem Substrat 50 angeordnet. Die Anschlusspins 33 ragen nach oben aus dem Gehäuse 60.

## Patentansprüche

1. HF-Klasse-D Verstärkeranordnung (10), die zum Betrieb an Versorgungsspannungen ≥100V und bei Ausgangsleistungen ≥ 1kW geeignet ist, mit einer aus zwei in Serie geschalteten schaltenden Elementen (11, 12), insbesondere MOSFETs, gebildeten Halbbrücke mit zwei Versorgungsspannungsanschlüssen (18, 19) und einem zwischen den schaltenden Elementen (11, 12) liegenden Ausgangsanschluss (24), wobei parallel zu der Serienschaltung der schaltenden Elemente (11, 12) ein Bypasskondensator (20) vorgesehen ist, **dadurch gekennzeichnet, dass** die in Serie geschalteten schaltenden Elementen (11, 12), insbesondere MOSFETs, jeweils als Halbleiterbausteine ausgebildet sind und auf einem gemeinsamen Substrat (50) angeordnet sind und dass Treiberbausteine (15, 16) als Halbleiterbausteine ebenfalls auf dem Substrat (50) angeordnet sind, wobei zwischen den Halbleiterbausteinen und Verbindungsleitungsabschnitten des Substrats (50) mehrere diese elektrisch leitend verbindende parallel geführte Anschlussleitungen (Bondingdrähte) angeordnet sind.

2. Verstärkeranordnung nach Anspruch 1, **dadurch gekennzeichnet, dass** die Halbbrücke und der Bypasskondensator (20) auf einer Fläche ≤ 30 cm² angeordnet sind.

3. Verstärkeranordnung nach einem der vorhergehenden Ansprüche, **dadurch gekennzeichnet, dass** der durch Kapazitäten und Induktivitäten im Strompfad durch die Halbbrücke und den Bypasskondensator (20) gebildete Schwingkreis eine Resonanzfrequenz ≥ 100 MHz aufweist.

4. Verstärkeranordnung nach einem der vorhergehenden Ansprüche, **dadurch gekennzeichnet, dass** Verbindungsleitungen (21, 22) zwischen dem Bypasskondensator (20) und den schaltenden Elementen (11, 12) sowie zwischen den schaltenden Elementen (11, 12) jeweils eine Länge ≤ 10mm, vorzugsweise ≤ 5mm, besonders bevorzugt ≤ 3mm aufweisen.

5. Verstärkeranordnung nach einem der vorhergehenden Ansprüche, **dadurch gekennzeichnet, dass** der Strompfad durch die schaltenden Elemente (11,12) und den Bypasskondensator (20) eine Länge ≤10 cm aufweist.

6. Verstärkeranordnung nach einem der vorhergehenden Ansprüche, **dadurch gekennzeichnet, dass** zumindest zwei Halbleiterbausteine (Dies) unmittelbar unter Auslassung von Verbindungsleitungsabschnitten des Substrats (50) miteinander verbunden (gebondet) sind.

7. Verstärkeranordnung nach einem der vorhergehenden Ansprüche, **dadurch gekennzeichnet, dass** zumindest eine Treiberanordnung (17) vorgesehen ist, die an die Steueranschlüsse (G1, G2) der schaltenden Elemente (11,12) angeschlossen ist, wobei die Verbindungsleitungen der Treiberanordnung (17) zu den schaltenden Elementen (11,12) eine Länge ≤10mm, vorzugsweise ≤ 5mm, besonders bevorzugt ≤ 3mm aufweisen.

8. Verstärkeranordnung nach einem der vorhergehenden Ansprüche, **dadurch gekennzeichnet, dass** zumindest die Halbbrücke und der Bypasskondensator (20) in einem Halbleiterbaustein integriert sind.

9. Verstärkeranordnung nach einem der vorhergehenden Ansprüche, **dadurch gekennzeichnet, dass** zumindest die schaltenden Elemente (11, 12) auf einem Kühlkörper (30) angeordnet sind.

10. Verstärkeranordnung nach Anspruch 9, **dadurch gekennzeichnet, dass** der Kühlkörper (30) aus Keramik ausgebildet ist.

11. Verstärkeranordnung nach einem der vorhergehenden Ansprüche, **dadurch gekennzeichnet, dass** der Bypasskondensator (20) über oder unter den schaltenden Elementen (11, 12) angeordnet ist.

12. Verstärkeranordnung nach einem der vorhergehenden Ansprüche, **dadurch gekennzeichnet, dass** der Bypasskondensator (20) als Substrat für die schaltenden Elemente (11, 12) ausgebildet ist.

13. Verstärkeranordnung nach einem der vorhergehenden Ansprüche, **dadurch gekennzeichnet, dass** zumindest die Halbbrücke und der Bypasskondensator (20) zu einem Modul zusammengefasst sind.

14. Verstärkeranordnung nach Anspruch 13, **dadurch gekennzeichnet, dass** außer Masseanschlüssen das Modul (10) keine Verbindung zu einem Kühlkörper (30) aufweist.

15. Verstärkeranordnung nach einem der vorhergehenden Ansprüche 9 bis 14, **dadurch gekennzeichnet, dass** alle Anschlüsse, an denen eine Spannung ≥100V anliegt, als Anschlusspins (33) oder Anschlussfahnen auf der dem Kühlkörper (30) gegenüber liegenden Seite angeordnet sind.

16. Verstärkeranordnung nach einem der vorhergehenden Ansprüche, **dadurch gekennzeichnet, dass** zwei in Reihe geschaltete Kondensatoren (36,37) zwischen den Versorgungsspannungsanschlüssen (18, 19) vorgesehen sind.

17. Verstärkeranordnung nach Anspruch 16, **dadurch gekennzeichnet, dass** diese Kondensatoren (36,37) auf einem Substrat (50) angeordnet sind, auf dem auch die schaltenden Elemente (11, 12) angeordnet sind.

18. Verstärkeranordnung nach Anspruch 16 oder 17 **dadurch gekennzeichnet, dass** die Anschlussleitungen zu den Kondensatoren (36, 37) eine Länge ≤10mm, vorzugsweise ≤ 5mm, besonders bevorzugt ≤ 3mm aufweisen.

19. Verstärkeranordnung nach einem der vorhergehenden Ansprüche, **dadurch gekennzeichnet, dass** jeweils ein Kondensator (39,40) zwischen der positiven Versorgungsspannung (18) und Masse (41) und der negativen Versorgungsspannung (19) und Masse (41) vorgesehen ist.

20. Verstärkeranordnung nach einem der vorhergehenden Ansprüche 9 bis 19, **dadurch gekennzeichnet, dass** der Kühlkörper (30) an Masse angeschlossen ist, wobei die Verbindungsleitung des Kühlkörpers (30) zu Masse eine Länge ≤10mm, vorzugsweise ≤ 5mm, besonders bevorzugt ≤ 3mm aufweist.

21. Verstärkeranordnung nach einem der vorhergehenden Ansprüche, **dadurch gekennzeichnet, dass** Verbindungsleitungen (21, 22) zwischen dem Bypasskondensator (20) und den schaltenden Elementen (11, 12) sowie zwischen den schaltenden Elementen (11, 12) jeweils eine Breite aufweisen die vergleichbar mit ihrer Länge ist.

22. HF-Generator mit einer Verstärkeranordnung nach einem der vorhergehenden Ansprüche.

23. HF-Plasma-Generator zur Versorgung eines Plasmas mit einer Verstärkeranordnung nach einem der vorhergehenden Ansprüche.

## Claims

1. An HF-class D amplifier arrangement (10), suitable for operation at supply voltages ≥ 100V and at output powers ≥1kW, with a half-bridge formed from two switching elements (11, 12), in particular MOSFETs, connected in series, with two supply voltage terminals (18, 19) and an output connection (24) between the switching elements (11, 12), wherein a bypass capacitor (20) is provided in parallel with the series circuit of the switching elements (11, 12), **characterized in that** the switching elements (11, 12), in particular MOSFETs, connected in series are each constructed as semiconductor components and arranged on a common substrate (50) and driver components (15, 16) in the form of semiconductor components are likewise arranged on the substrate (50), wherein multiple parallel terminal leads (bonding wires) are arranged between the semiconductor components and connection lead sections of the substrate (50), connecting these in an electrically conducting manner.

2. The amplifier arrangement according to claim 1, **characterized in that** the half-bridge and the bypass capacitor (20) are arranged on an area of ≤30 cm².

3. The amplifier arrangement according to any one of the preceding claims, **characterized in that** the resonant circuit formed by capacitances and inductances in the current path through the half-bridge and the bypass capacitor (20) has a resonance frequency ≥ 100 MHz.

4. The amplifier arrangement according to any one of the preceding claims, **characterized in that** connection leads (21, 22) between the bypass capacitor (20) and the switching elements (11, 12) and between the switching elements (11, 12) each have a length ≤10mm, preferably ≤5mm, particularly preferably ≤3mm.

5. The amplifier arrangement according to any one of the preceding claims, **characterized in that** the current path through the switching elements (11, 12) and the bypass capacitor (20) has a length of ≤10 cm.

6. The amplifier arrangement according to any one of the preceding claims, **characterized in that** at least two semiconductor components (dies) are directly interconnected (bonded) with the omission of connection lead sections of the substrate (50).

7. The amplifier arrangement according to any one of the preceding claims, **characterized in that** at least one driver arrangement (17) is provided, which is connected to the control terminals (G1, G2) of the switching elements (11, 12), wherein the connection leads from the driver arrangement (17) to the switching elements (11, 12) have a length of ≤10mm, preferably ≤5mm, particularly preferably ≤3mm.

8. The amplifier arrangement according to any one of the preceding claims, **characterized in that** at least the half-bridge and the bypass capacitor (20) are integrated in a semiconductor component.

9. The amplifier arrangement according to any one of the preceding claims, **characterized in that** at least the switching elements (11, 12) are arranged on a heat sink (30).

10. The amplifier arrangement according to claim 9, **characterized in that** the heat sink (30) is constructed of ceramic material.

11. The amplifier arrangement according to any one of the preceding claims, **characterized in that** the bypass capacitor (20) is arranged above or below the switching elements (11, 12).

12. The amplifier arrangement according to any one of the preceding claims, **characterized in that** the bypass capacitor (20) is constructed as a substrate for the switching elements (11, 12).

13. The amplifier arrangement according to any one of the preceding claims, **characterized in that** at least the half-bridge and the bypass capacitor (20) are combined together into a module.

14. The amplifier arrangement according to claim 13, **characterized in that** apart from ground connections the module (10) has no connection to a heat sink (30).

15. The amplifier arrangement according to any one of the preceding claims 9 to 14, **characterized in that** all terminals, on which a voltage ≥100V is present, are arranged as terminal pins (33) or terminal tags on a side opposite to the heat sink (30).

16. The amplifier arrangement according to any one of the preceding claims, **characterized in that** two capacitors (36, 37) connected in series are provided between the supply voltage terminals (18, 19).

17. The amplifier arrangement according to claim 16, **characterized in that** these capacitors (36, 37) are arranged on a substrate (50), on which the switching elements (11, 12) are also arranged.

18. The amplifier arrangement according to claim 16 or 17, **characterized in that** the terminal leads to the capacitors (36, 37) have a length of ≤ 10mm, preferably ≤ 5mm, particularly preferably ≤ 3mm.

19. The amplifier arrangement according to any of the preceding claims, **characterized in that** one capacitor (39, 40) respectively is provided between the positive supply voltage (18) and ground (41), and the negative supply voltage (19) and ground (41).

20. The amplifier arrangement according to any one of the preceding claims 9 to 19, **characterized in that** the heat sink (30) is connected to ground, wherein the connection lead from the heat sink (30) to ground has a length of ≤ 10mm, preferably ≤5mm, particularly preferably ≤3mm.

21. The amplifier arrangement according to any one of the preceding claims, **characterized in that** connection leads (21, 22) between the bypass capacitor (20) and the switching elements (11, 12) and between the switching elements (11, 12) each have a width that is comparable with their length.

22. An HF generator with an amplifier arrangement according to any one of the preceding claims.

23. An HF-plasma generator for supplying a plasma with an amplifier arrangement according to any one of the preceding claims.

## Revendications

1. Dispositif amplificateur HF (10) de classe D, se prêtant au fonctionnement à des tensions d'alimentation ≥ 100 V et à des puissances de sortie ≥ 1 kW, comprenant un demi-pont formé de deux éléments commutateurs (11, 12) branchés en série, en particulier des MOSFET, comportant deux connexions à des tensions d'alimentation (18, 19) et une connexion de sortie (24) interposée entre les éléments commutateurs (11, 12), un condensateur de dérivation (20) étant prévu en parallèle au branchement en série desdits éléments commutateurs (11, 12), **caractérisé par le fait que** les éléments commutateurs (11, 12) branchés en série, notamment des MOSFET, sont respectivement réalisés sous la forme de composants semi-conducteurs et sont implantés sur un substrat commun (50) ; et **par le fait que** des composants excitateurs (15, 16), se présentant comme des composants semi-conducteurs, sont pareillement implantés sur ledit substrat (50), sachant que plusieurs conducteurs de raccordement (fils de connexion), dont les tracés sont parallèles, sont interposés entre lesdits composants semi-conducteurs et des tronçons de conducteurs de jonction dudit substrat (50), dont ils assurent la liaison électriquement conductrice.

2. Dispositif amplificateur selon la revendication 1, **caractérisé par le fait que** le demi-pont et le condensateur de dérivation (20) sont implantés sur une surface ≤ 30 cm².

3. Dispositif amplificateur selon l'une des revendications précédentes, **caractérisé par le fait que** le circuit oscillant, formé par des capacités et des inductances sur le trajet de courant circulant par le demi-pont et par le condensateur de dérivation (20), présente une fréquence de résonance ≥ 100 MHz.

4. Dispositif amplificateur selon l'une des revendications précédentes, **caractérisé par le fait que** des conducteurs de jonction (21, 22) situés entre le condensateur de dérivation (20) et les éléments commutateurs (11, 12), ainsi qu'entre lesdits éléments commutateurs (11, 12), offrent respectivement une longueur ≤ 10 mm, de préférence ≤ 5 mm, et ≤ 3 mm avec préférence particulière.

5. Dispositif amplificateur selon l'une des revendications précédentes, **caractérisé par le fait que** le trajet de courant, circulant par les éléments commutateurs (11, 12) et par le condensateur de dérivation (20), présente une longueur ≤ 10 cm.

6. Dispositif amplificateur selon l'une des revendications précédentes, **caractérisé par le fait qu'**au moins deux composants semi-conducteurs (matrices) sont directement reliés (connectés) l'un à l'autre, en réservant des tronçons de conducteurs de jonction du substrat (50).

7. Dispositif amplificateur selon l'une des revendications précédentes, **caractérisé par** la présence d'au moins un dispositif d'excitation (17) raccordé aux connexions de commande (G1, G2) des éléments commutateurs (11, 12), les conducteurs, instaurant la jonction dudit dispositif d'excitation (17) avec lesdits éléments commutateurs (11, 12), présentant une longueur ≤ 10 mm, de préférence ≤ 5 mm, et ≤ 3 mm avec préférence particulière.

8. Dispositif amplificateur selon l'une des revendications précédentes, **caractérisé par le fait qu'**au moins le demi-pont, et le condensateur de dérivation (20), sont intégrés dans un composant semi-conducteur.

9. Dispositif amplificateur selon l'une des revendications précédentes, **caractérisé par le fait qu'**au moins les éléments commutateurs (11, 12) sont implantés sur un corps de refroidissement (30).

10. Dispositif amplificateur selon la revendication 9, **caractérisé par le fait que** le corps de refroidissement (30) consiste en de la céramique.

11. Dispositif amplificateur selon l'une des revendications précédentes, **caractérisé par le fait que** le condensateur de dérivation (20) est placé au-dessus ou au-dessous des éléments commutateurs (11, 12).

12. Dispositif amplificateur selon l'une des revendications précédentes, **caractérisé par le fait que** le condensateur de dérivation (20) est réalisé sous la forme d'un substrat dédié aux éléments commutateurs (11, 12).

13. Dispositif amplificateur selon l'une des revendications précédentes, **caractérisé par le fait qu'**au moins le demi-pont, et le condensateur de dérivation (20), sont regroupés en un module.

14. Dispositif amplificateur selon la revendication 13, **caractérisé par le fait que** le module (10) ne comporte aucune jonction avec un corps de refroidissement (30), à l'exception de connexions à la masse.

15. Dispositif amplificateur selon l'une des revendications 9 à 14 précédentes, **caractérisé par le fait que** toutes les connexions, auxquelles une tension ≥ 100 V est appliquée, sont implantées sur le côté pointant à l'opposé du corps de refroidissement (30), en tant que broches de raccordement (33) ou languettes de raccordement.

16. Dispositif amplificateur selon l'une des revendications précédentes, **caractérisé par le fait que** deux condensateurs (36, 37), branchés en série, sont prévus entre les connexions à des tensions d'alimentation (18, 19).

17. Dispositif amplificateur selon la revendication 16, **caractérisé par le fait que** les condensateurs précités (36, 37) sont implantés sur un substrat (50) sur lequel les éléments commutateurs (11, 12) sont également implantés.

18. Dispositif amplificateur selon la revendication 16 ou 17, **caractérisé par le fait que** les conducteurs de raccordement aux condensateurs (36, 37) offrent une longueur ≤ 10 mm, de préférence ≤ 5 mm, et ≤ 3 mm avec préférence particulière.

19. Dispositif amplificateur selon l'une des revendications précédentes, **caractérisé par le fait qu'**un condensateur (39, 40) est respectivement prévu entre la masse (41) et la tension d'alimentation (18) positive, et entre ladite masse (41) et la tension d'alimentation (19) négative.

20. Dispositif amplificateur selon l'une des revendications 9 à 19 précédentes, **caractérisé par le fait que** le corps de refroidissement (30) est raccordé à la masse, sachant que le conducteur, instaurant le raccordement dudit corps de refroidissement (30) à la masse, offre une longueur ≤ 10 mm, de préférence ≤ 5 mm, et ≤ 3 mm avec préférence particulière.

21. Dispositif amplificateur selon l'une des revendications précédentes, **caractérisé par le fait que** des conducteurs de jonction (21, 22) situés entre le condensateur de dérivation (20) et les éléments commutateurs (11, 12), ainsi qu'entre lesdits éléments commutateurs (11, 12), offrent respectivement une largeur comparable à leur longueur.

22. Générateur HF équipé d'un dispositif amplificateur conforme à l'une des revendications précédentes.

23. Générateur de plasma HF pour l'alimentation d'un plasma, équipé d'un dispositif amplificateur conforme à l'une des revendications précédentes.
